# EUROPÄISCHE PATENTSCHRIFT

(11) **EP 1 014 434 B1**
(45) Veröffentlichungstag und Bekanntmachung des Hinweises auf die Patenterteilung: **26.03.2008**
(21) Anmeldenummer: 99123893.2
(22) Anmeldetag: 02.12.1999
(51) Int. Cl.: H01L 21/311

(54) **Verfahren zum anisotropen plasmachemischen Trockenätzen von Siliziumnitrid-Schichten mittels eines Fluor-enthaltenden Gasgemisches**
Method for anisotropically plasma dry-etching a silicon nitride layer with a gas mixture containing fluorine
Méthode pour la gravure plasma anisotrope par voie sèche d'une couche de nitrure de silicium par un mélange gazeux contenant du Fluor

(30) Priorität: 24.12.1998 DE 19860271; 17.11.1999 DE 19955145
(43) Veröffentlichungstag der Anmeldung: 28.06.2000
(73) Patentinhaber: ATMEL Germany GmbH, 74072 Heilbronn (DE)
(72) Erfinder: Gellrich, Norbert, Dr., 74252 Massenbachhausen (DE); Kirchmann, Rainer, 74172 Neckarsulm (DE)
(74) Vertreter: Müller, Wolf-Christian

(56) Entgegenhaltungen:
- DE-A- 3 318 566
- US-A- 4 857 140
- US-A- 5 013 398
- US-A- 5 854 136
- PATENT ABSTRACTS OF JAPAN vol. 018, no. 008 (E-1486), 7. Januar 1994 (1994-01-07) & JP 05 251399 A (NEC CORP), 28. September 1993 (1993-09-28)
- PATENT ABSTRACTS OF JAPAN vol. 014, no. 154 (E-0907), 23. März 1990 (1990-03-23) & JP 02 012915 A (SHARP CORP), 17. Januar 1990 (1990-01-17)

## Beschreibung

Die Erfindung betrifft ein Verfahren zum anisotropen plasmachemischen Trockenätzen von Siliziumnitridschichten mittels eines Gasgemisches das SF₆ und CHF₃ enthält, gemäß des Oberbegriff des Patentanspruch 1.

Das plasmachemische Trockenätzen, auch RIE-Ätzen genannt, wird bei der Herstellung von Halbleiterschaltkreisen angewandt. Vorteil des Trockenätzens gegenüber einer Naßätzung ist, daß damit Strukturen unter 1 µm hergestellt werden können. Dies ist beispielsweise für die Herstellung von integrierten Schaltkreisen mit SiGe Transistoren notwendig.

Aus US 5 433 823 ist ein Verfahren zur sogenannten Padfensterätzung bekannt, das eine Mischung aus SF₆ und CHF₃ verwendet. Die verwendeten Gasflüsse liegen für CHF₃ bei 180 sccm für SF₆ bei 20 sccm. Das darin beschriebene Verfahren dient zur Ätzung von einer passivierenden Halbleiterschichtfolge von ca 1 µm dicken Schicht aus Si₃N₄ und einer darunterliegenden ca 0.5 µm dicken Schicht aus SiO₂, die selektiv zu einer unter den beiden Halbleiterschichten liegenden Metallschicht aus TiW geätzt wird. Die zu ätzenden Strukturgrößen liegen dabei im Bereich von 100 µm. Aus der Tabelle 3 in US 5 433 823 ergibt sich, daß durch Zugabe von CHF₃ zu SF₆ die Selektivität von Siliziumnitrid zu Siliziumoxid von 1.6 auf 0.8 abnimmt.

Bei bekannten Verfahren werden CF₄, CHF₃ oder andere fluorhaltige Gase zusammen mit O₂ eingesetzt, wie beispielsweise der WO96/16437 entnommen werden kann. Aus der EP 0 706 206 A2 ist ebenfalls ein Ätzverfahren bekannt, bei dem CF₄ +O₂ eingesetzt wird.

Für alle Trockenätzverfahren unter Verwendung von O₂ als ein Bestandteil des Gasgemisches ergibt sich der wesentliche Nachteil, daß dies nicht für Reaktorräumen von Trockenätzanlagen mit oxidierenden Elektrodenmaterialen, wie Silizium oder Kohlenstoff, einsetzbar ist, da diese unter Sauerstoffeinfluß angegriffen würden.

Ein anderes Verfahren ist beispielsweise aus der DE 37 14 144 C2 bekannt. Dort wird vorgeschlagen, als Gasgemisch ein fluorhaltiges Gas mit Chlor oder Brom einzusetzen. Da diese Gase korrosiv und giftig sind, können sie ebenfalls nicht in allen Reaktoren eingesetzt werden.

Aus der DE 42 32 475 A1 ist ein plasmachemisches Trockenätzverfahren für Siliziumnitridschichten selektiv zu Siliziumoxidschichten zu entnehmen, bei denen als Ätzgase Verbindungen eingesetzt werden, bei denen jeweils ein Fluoratom und mindestens ein Atom aus der Gruppe Chlor, Brom und Jod in der Molekülstruktur an ein Kohlenstoffgerüst chemisch gebunden sind.

Aus der WO 96/16433 ist ein anisotropes und selektives Trockenätzverfahren für Siliziumnitride über dünnen Siliziumoxidschichten zu entnehmen, bei dem nur Cl₂ als Ätzgas eingesetzt wird, was zu sehr niedrigen Ätzraten führt, die für dickere Schichten nicht praktikabel sind.

Auch aus der EP 0 516 053 A2 kann ein Verfahren entnommen werden, bei dem als Ätzgas eine Mischung von S₂F₂, SF₂, SF₄ oder S₂F₁₀ mit einem Edelgas verwendet wird, um SiO₂ selektiv zu Si₃N₄ zu ätzen. Dabei wird beschrieben, daß der freiwerdende Schwefel sich als passivierende Sicht an Si₃N₄-Flächen bildet und das Ätzen des Si₃N₄ verhindert.

Ein weiteres Verfahren ist aus der Druckschrift US 5710713 bekannt. Hierbei wird ein nicht oxidierendes Verfahren unter Verwendung von Argon zur Ätzung von Kontaktlöchern offenbart. Hierbei wird auch eine dünne Nitridabdeckschicht geätzt. Weitere Verfahren zur Trockenätzung sind aus den Druckschriften US, 5854136A, SG 52845A, US 4857140A, US 5013398 A und aus Patent Abstracts of Japan, vol. 018, no. 008 (E-1486) bekannt.

Neben den oben genannten Nachteilen beim Einsatz von Sauerstoff und Halogeniden (Cl₂, Br) haben Untersuchungen der Anmelderin gezeigt, daß alle bisherigen bekannten Prozesse keine ausreichende Kontrolle des Kantenwinkels der zu ätzenden Siliziumnitridschicht erlauben. Mit Ausnahme des bekannten Padfensterprozesses gemäß der oben erwähnten US 5 433 823 sind bei den in der Literatur beschriebenen Prozessen die Si₃N₄-Dicken kleiner als etwa 150 nm, so daß eine Kontrolle des Kantenwinkels nicht notwendig ist. Liegt die Schichtdicke oberhalb von 150 nm bzw hat der Kantenwinkel für das zu erzeugende Bauelement eine wichtige Funktion, reichen die bisherigen Verfahren nicht aus.

Aufgabe der vorliegenden Erfindung ist es, ein Verfahren der eingangs beschriebenen Art vorzustellen, das eine genaue Einstellung des Kantenwinkels einer zu ätzenden Siliziumnitridschicht bei gleichzeitig guter Selektivität zu einer unterliegenden SiO₂ Schicht erlaubt.

Diese Aufgabe wird durch die Merkmale des Patentanspruchs 1 gelöst. Vorteilhafte Weiterbildungen sind den Unteransprüchen zu entnehmen.

Das erfindungsgemäße Verfahren wird durchgeführt, indem ein nichtoxidierendes Gas dem Gasgemisch aus CHF₃ und SF₆. hinzugefügt wird.

Untersuchungen der Anmelderin haben gezeigt, daß die Mischung von CHF₃ und SF₆ sowie einem nichtoxidierenden Gas in unerwarteter Weise sehr gute Prozeßeigenschaften zeigt, insbesondere eine gute Selektivität von Siliziumnitrid zu Siliziumoxid bei hohen Ätzraten und sich gleichzeitig der Kantenwinkel der zu ätzenden Siliziumnitridschicht einstellen läßt. Offensichtlich dienen diese beiden Gase nicht nur als Lieferanten des ätzenden Fluors, sondern gerade die Mischung der Bestandteile aus Kohlenwasserstoff und Schwefel mit einem nichtoxidierenden Gas führt zu den unerwartet neuen Eigenschaften. Dabei fungiert das nichtoxidierende Gas nicht als Trägergas, sondern stellt über eine Wechselwirkung mit den anderen Gasen eine aktive Ätzkomponente dar. Vorteil der hohen Siliziumnitridätzraten ist es, daß bei definiertem Kantenwinkel auch dicke Siliziumnitridschichten, deren Dicke 200 nm übersteigen kann, in geringer Prozeßzeit sich ätzen lassen. Weiterer Vorteil des Verfahren ist es, daß, sofern ein senkrechter Kantenwinkel der zu ätzenden Siliziumnitridschicht eingestellt wird, diese Kante in nachfolgenden Prozeßschritten mit beispielsweise einem Siliziumoxidspacer versehen werden kann.

Dadurch, daß dem erfindungsgemäßen Verfahren für das nichtoxidierende Gas Argon eingesetzt wird kann bereits bei kleinen zugaben von CHF₃ zu SF₆ eine Selektivität von Siliziumnitrid zu Siliziumoxid bis über 2 erreicht werden. Von vorteil von Argon im vergleich Helium ist dabei, daß sich vermutlich über das verhältnismäßig hohe Atomgewicht von Argon, eine besonders gute Gleichmäßigkeit der Siliziumnitridätzrate über der Siliziumscheibenfläche erreichen läßt. Damit ist es möglich, mit kurzen überätzzeiten, beispielweise 15% der Gesamtätzzeit, die Siliziumnitridschicht vollständig zu entfernen. Durch entsprechende Wahl der Prozeßparameter des Trockenätzprozesses, insbesondere der Flüsse des Gasgemisches, des Druckes in der Reaktorkammer der Trockenätzanlage, der Plasmaleistung des RF-Generators und des Elektrodenabstandes kann damit ein Kantenwinkelbereich von über 20 Grad abgedeckt werden.

Durch den Zusatz eines nichtoxidierendem Gas, anstelle von Sauerstoff und Halogeniden zu SF₆ und CHF₃ ist das erfindungsgemäße Verfahren auch in Reaktorräumen mit oxidierenden Elektroden anwendbar.

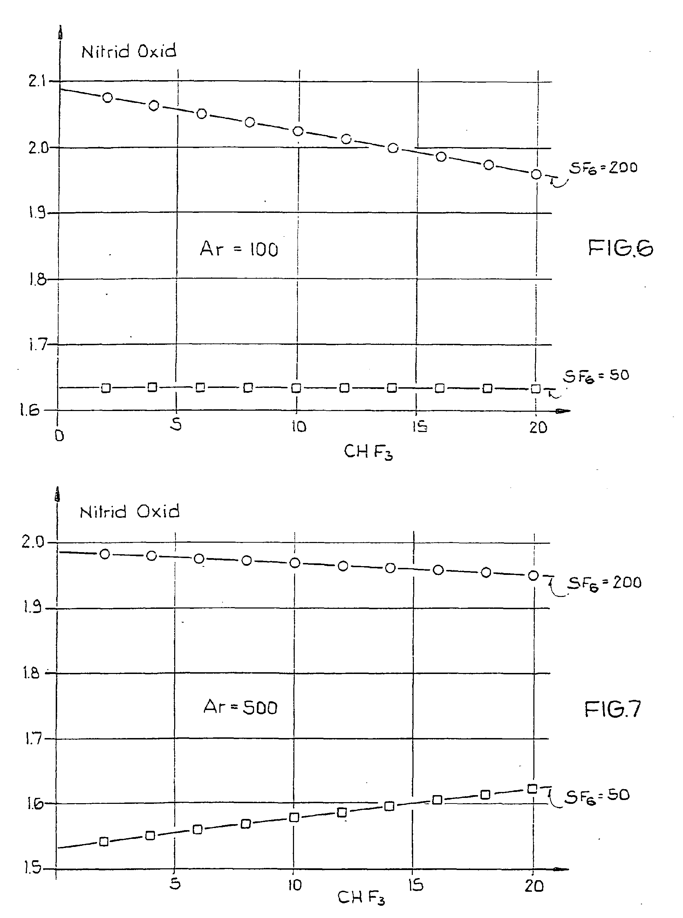

Nachfolgend wird die Erfindung anhand eines Ausführungsbeispiels und der Zeichnungsunterlagen Fig,1 bis Fig. 7 näher erläutert. Dabei zeigt:
Fig. 1 den Aufbau der Halbleiterschichten im bereits geätzten Zustand
Fig. 2 die Abhängigkeit des Kantenwinkels für einen Argonfluß von 100 sccm, als Funktion des SF₆ Gasflusses, parametrisiert nach CHF₃
Fig.3 die Abhängigkeit des Kantenwinkels für einen Argonfluß von 500 sccm, als Funktion des SF₆ Gasflusses, parametrisiert nach CHF₃
Fig.4 die Abhängigkeit des Kantenwinkels für einen Argonfluß von 100 sccm, als Funktion der CHF₃ Gasflusses, parametrisiert nach SF₆
Fig.5 die Abhängigkeit des Kantenwinkels für einen Argonfluß von 500 sccm, als Funktion der CHF₃ Gasflusses, parametrisiert nach SF₆
Fig.6 die Abhängigkeit der Selektivität von Siliziumnitrid zu Siliziumoxid für einen Argonfluß von 100 sccm, als Funktion der Gasflüsse SF₆ und CHF₃, parametrisiert nach SF₆
Fig.7 die Abhängigkeit der Selektivität von Siliziumnitrid zu Siliziumoxid für einen Argonfluß von 500 sccm, als Funktion der Gasflüsse SF₆ und CHF₃, parametrisiert nach SF₆

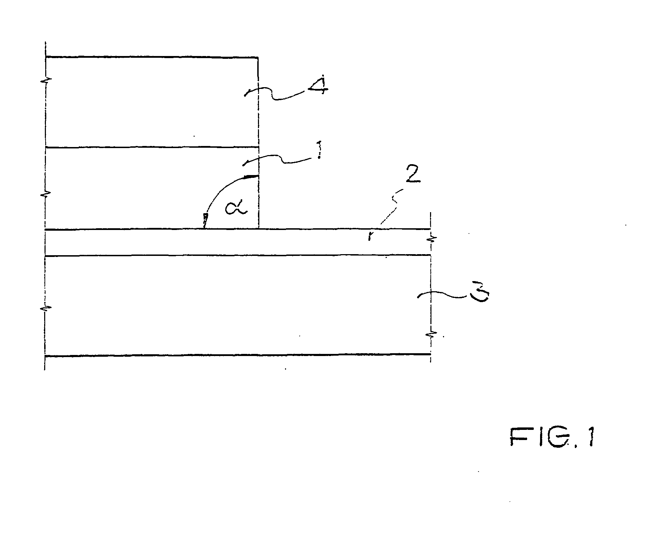

Unter Bezugnahme auf die Fig. 1 wird zunächst anhand eines Querschnitts, der den bereits geätzten Zustand zeigt, die Schichtfolge der Halbleiterstruktur erklärt. Prozeßtechnischer Ausgangspunkt ist das Aufbringen einer ersten Schicht **2** aus SiO₂ auf ein Ausgangsmaterial **3,** beispielsweise bestehend aus Silizium. Bei Silizium kann dies sowohl durch thermische Siliziumoxidation des Grundmaterials **3**, als auch durch Abscheiden in einer CVD oder PECVD Anlage erfolgen. Anschließend wird eine zweite Schicht **1** aus Si₃N₄ aufgebracht, deren Dicke durchaus 400 nm und mehr annehmen kann. Eine solche dicke Siliziumnitridschicht ist beispielsweise erforderlich, um an der geätzten Kante der Siliziumnitridschicht einen Siliziumoxidspacer erzeugen zu können. Die Abscheidung der Siliziumnitridschicht kann in einem vertikal System (VTR-Reaktor) wie auch in einer CVD/PECVD Anlage erfolgen. Im anschließenden Gelbraumprozeß wird eine Lackschicht **4** aufgebracht und fotochemisch strukturiert. Danach wird die zweite 1, bestehend aus Siliziumnitrid in einer konventionellen RIE-Anlage nach dem erfindungsgemäßen Verfahren strukturiert. Hierzu wird eine Gasmischung aus SF₆ und CHF₃ sowie Argon zugeführt. Durch Wahl der Prozeßparameter Druck, Plasmaleistung und Gasflüsse wird dabei der Kantenwinkel α der zu ätzenden Siliziumnitridschicht **1** und die Selektivität, d.h. das Verhältnis der Ätzrate von Siliziumnitrid zu Siliziumoxid genau eingestellt.

Für das Ätzen der Siliziumnitridschicht **1** mit einer Dicke von 400 nm führt beispielweise ein Druck von ca. 450 mTorr, eine Plasmaleistung von 300 Watt, ein Argonfluß von ca. 500 sccm, ein SF₆-Fluß von ca. 200 sccm und ein CHF₃-Fluß von ca. 7 sccm zu einer Selektivität von etwa 2 von Si₃N₄ zu SiO₂ und zu einem senkrechten Kantenwinkel. Das zur Anlage gehörige optische Endpunkterkennungssystem erlaubt eine automatische Abschaltung des Ätzvorganges, sobald das Erreichen des Endpunktes angezeigt wird. Wichtig dabei ist, daß nach Erkennung des Endpunktsignals die überätzzeit kurz gehalten wird, um möglichst wenig von der unterliegenden Siliziumoxidschicht **2** zu verlieren. So erfordert eine 400 nm dicke Siliziumnitridschicht **1** in Verbindung mit der Selektivität von 2 und der notwendigen Überätzzeit die stattfinden muß, um eine sichere Entfernung der Siliziumnitridschicht auf der gesamten Silizium Scheibe zu gewährleisten, eine Siliziumoxiddicke von mindestens 40 nm.

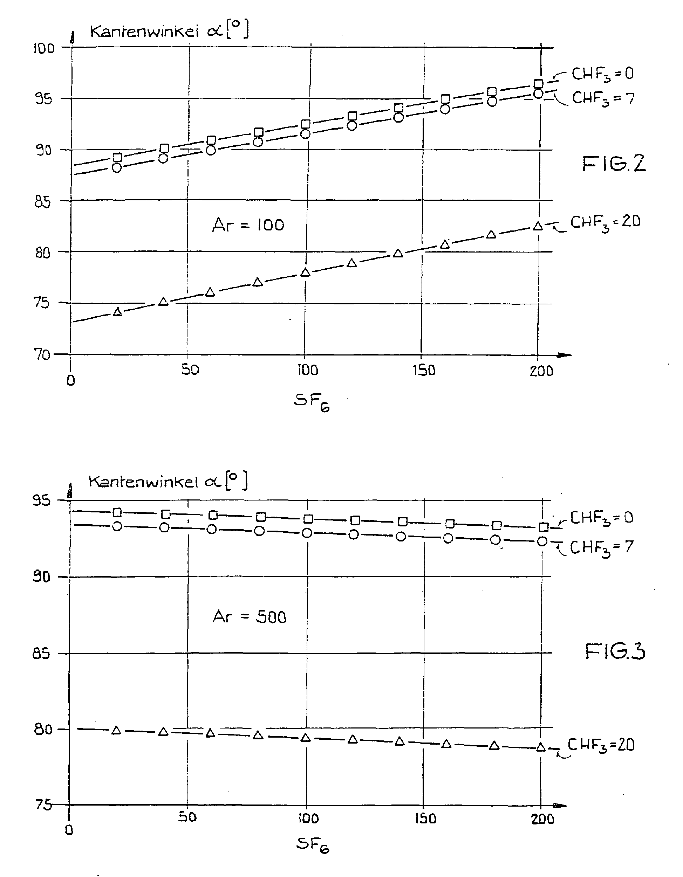

Die Figuren 2 - 7 zeigen für einen Teil des untersuchten Prozeßparameterbereiches die funktionalen Abhängigkeiten des Kantenwinkels α als auch der Selektivität von den Gasflüssen. Dabei wurde für ein nicht oxidierendes Gas Argon verwendet.

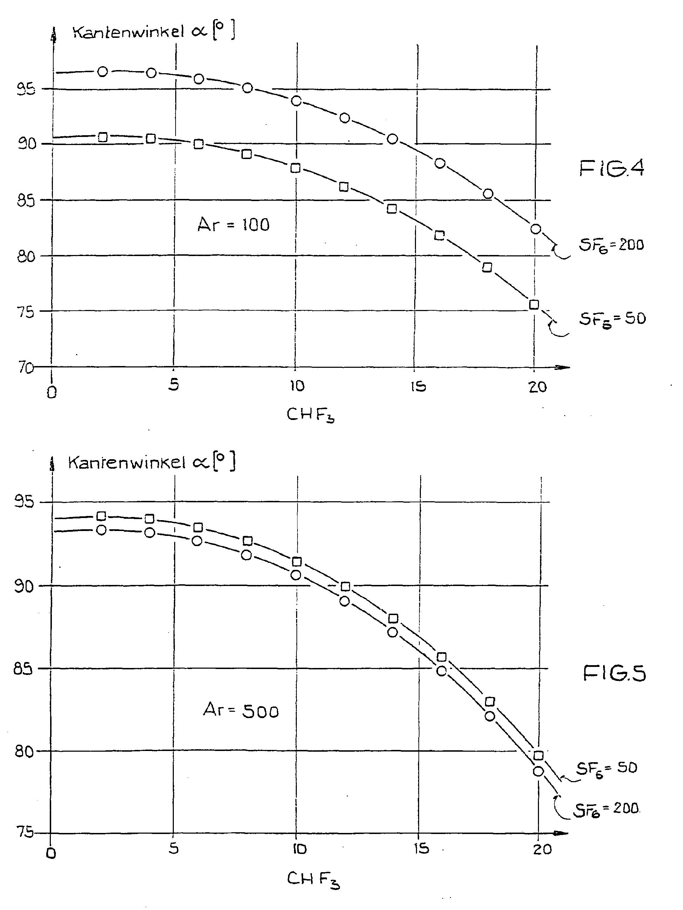

Es zeigt sich in Fig.2 und Fig.3, daß bei einem niedrigen Argonfluß der Kantenwinkel α mit zunehmenden SF₆-Fluß linear um mehr als 7 Grad steigt, demhingegen bei hohem Argonfluß der Kantenwinkel mit zunehmenden SF₆-Fluß linear fällt. Wird hingegen der CHF₃-Fluß, wie in Fig.4 und Fig.5 dargestellt, variiert, zeigt sich, daß bei steigendem CHF₃-Fluß der Kantenwinkel ab 10 sccm stark fällt. Sofern senkrechte Siliziumnitridkanten erforderlich sind, wird entsprechend der dargestellten Abhängigkeit bei CHF₃-Flüssen um 10 sccm gearbeitet.

Für die Selektivität von Siliziumnitrid zu Siliziumoxid bei beispielsweise einem SF₆-Fluß von 50 sccm ergibt sich aus Fig.6 und Fig.7, daß bei niedrigem Argonfluß die Selektivität mit steigendem CHF₃-Fluß konstant bleibt, demhingegen sie bei hohen Argonflüssen mit steigendem CHF₃-Fluß ebenfalls steigt.

Bei dem erfindungsgemäßen Trockenätzverfahren liegen die grundsätzlichen Prozeßparameter, wie der Druck in einem Bereich von 200 - 500 mTorr, die Plasmaleistung in einem Bereich von 100 - 600 Watt, der Argonfluß in einem Bereich von 100 bis 700 sccm, der SF₆-Fluß in einem Bereich von 30 bis 300 sccm und der CHF₃-Fluß in einem Bereich von 1 bis 50 sccm, wobei die konkrete Zusammenstellung der Prozeßparameter von den Bedingungen des Einzelfalls, wie in den Abbildungen dargestellt, insbesondere von der gewünschten Ätzrate und des Kantenwinkels sowie der Selektivität abhängt. Des weiteren wird die Siliziumscheibe auf der Rückseite mit Helium gekühlt und so auf einer Temperatur von ca. 0 Grad Celsius gehalten. Aufgrund seines guten Durchsatzes infolge der hohen Siliziumnitridätzrate und seiner guten Gleichmäßigkeit ist der Prozeß fertigungstauglich.

## Patentansprüche

1. Verfahren zur Optimierung des Prozesszustandes vor der Ausbildung von Spacem an einer ersten Siliziumnitridschicht, wobei ein selektives anisotropes plasmachemisches Trockenätzen von einer ersten Schicht (1) aus Si₃N₄ , deren Dicke 200nm übersteigt, mit einer deren Oberfläche maskierenden Schicht (4) und einer unter der ersten Schicht liegenden zweiten Schicht (2) aus SiO₂,durchgeführt wird,
**dadurch gekennzeichnet, dass**
- ein Kantenwinkel α der zu ätzenden ersten Schicht (1) im Kantenbereich der zu maskierenden Schicht (4) in einem Bereich von 75 bis 95 Grad eingestellt wird,
- eine Selektivität der Ätzung der ersten Schicht (1) zur zweiten Schicht (2) im Bereich von 1.5 bis 2.2 eingestellt wird.
- indem für ein Gasgemisch das SF₆ und CHF₃ und Ar enthält der SF₆-Fluß zwischen 50 und 300 sccm, der CHF₃-Fluß zwischen 1 und 20 sccm und der Ar-Fluß zwischen 100 und 700 sccm eingestellt wird.

2. Verfahren nach Anspruch 1, **dadurch gekennzeichnet, dass** mit einem SF₆-Fluß von 200 sccm, und einem CHF₃-Fluß von 7 sccm und einem Ar-Fluß von 500 sccm ein Kantenwinkel α von 90 Grad und eine Selektivität der ersten Schicht zur zweiten Schicht von 1.9 eingestellt wird.

3. Verfahren nach einem der vorangegangenen Ansprüche in Reaktoren mit oxidierenden Elektroden.

## Claims

1. Method for optimisation of the process state prior to formation of spacers at a first silicon nitride layer, wherein a selective anistropic plasma-chemical dry etching of a first layer (1) of Si₃N₄, the thickness of which exceeds 200 nm, is carried out with a layer (4) masking the surface thereof and a second layer (2) of SiO₂ lying under the first layer,
**characterised in that**
- an edge angle α of the first layer (1) to be etched is set in the edge region of the layer (4), which is to be masked, in a range of 75 to 95 degrees,
- a selectivity of the etching of the first layer (1) relative to the second layer (2) is set in the range of 1.5 to 2.2,
- **in that** for a gas mixture containing SF₆ and CHF₃ and Ar the SF₆ flow is set between 50 and 300 sccm, the CHF₃ flow between 1 and 20 sccm and the Ar flow between 100 and 700 sccm.

2. Method according to claim 1, **characterised in that** an edge angle α of 90 degrees and a selectivity of the first layer relative to the second layer of 1.9 are set with a SF₆ flow of 200 sccm, a CHF₃ flow of 7 sccm and an Ar flow of 500 sccm.

3. Method according to one of the preceding claims in reactors with oxidising electrodes.

## Revendications

1. Procédé d'optimisation de l'état d'un processus avant la conformation de "spacer" sur une première couche de nitrure de silicium, selon lequel on effectue une gravure sèche sélective anisotrope plasmachimique d'une première couche (1) en Si₃N₄, dont l'épaisseur dépasse 200 nm, avec une couche (4) masquant la surface de celle-ci et une deuxième couche (2) en SiO₂ située sous la première, **caractérisé en ce que** :
- l'on règle un angle d'arête α de la première couche (1) à graver dans la zone d'arête de la couche à masquer (4) sur une plage allant de 75 à 95 degrés,
- l'on règle une sélectivité de la gravure de la première couche (1) par rapport à la deuxième couche sur une plage allant de 1,5 à 2,2,
- en réglant, pour un mélange gazeux contenant du SF₆, du CHF₃ et de l'Ar, le débit de SF₆ entre 50 et 300 c³/mn, le débit de CHF₃ entre 1 et 20 c³/mn et le débit d'Ar entre 100 et 700 c³/mn.

2. Procédé selon la revendication 1, **caractérisé en ce que** pour un débit de SF₆ de 200 c³/mn, un débit de CHF₃ de 7 c³/mn et un débit d'Ar de 500 c³/mn on règle un angle d'arête α de 90 degrés et une sélectivité de la première couche par rapport à la deuxième couche de 1,9.

3. Procédé selon l'une quelconque des revendications précédentes utilisé dans des réacteurs à électrodes oxydantes.
